## Europäisches Patentamt
## European Patent Office
## Office européen des brevets

(19)

(11) Numéro de publication: **0 046 422**
**B1**

(12) # FASCICULE DE BREVET EUROPEEN

(45) Date de publication du fascicule du brevet:
**13.11.85**

(21) Numéro de dépôt: **81401224.1**

(22) Date de dépôt: **29.07.81**

(51) Int. Cl.⁴: **H 01 L 29/78,** H 01 L 29/80, H 01 L 29/62

(54) **Transistor à effet de champ GaAs à mémoire non-volatile.**

(30) Priorité: **20.08.80 FR 8018186**

(43) Date de publication de la demande:
**24.02.82 Bulletin 82/8**

(45) Mention de la délivrance du brevet:
**13.11.85 Bulletin 85/46**

(84) Etats contractants désignés:
**DE GB IT NL**

(56) Documents cités:
**EP - A - 0 017 531**
**EP - A - 0 027 761**
**US - A - 4 160 261**

(73) Titulaire: **THOMSON-CSF, 173, Boulevard Haussmann, F-75379 Paris Cedex 08 (FR)**

(72) Inventeur: **Nuyen, Trong Linh, THOMSON-CSF SCPI 173, bld Haussmann, F-75360 Paris Cedex 08 (FR)**

(74) Mandataire: **Taboureau, James, THOMSON-CSF SCPI 173, Bld Haussmann, F-75379 Paris Cedex 08 (FR)**

BUNDESDRUCKEREI BERLIN

## Description

La présente invention concerne les transistors à effet de champ présentant un effet de mémoire non-volatile, de type métal-isolant-semiconducteur (MIS) dans lequel le semiconducteur est un composé du groupe III-IV et l'isolant est une double couche diélectrique.

Les transistors MIS sur silicium sont bien connus. Dans le cas du silicium, on connait plusieurs types d'isolants, dont la qualité se réfère aux différents critères suivant:

— faible densité de défauts dénommés états d'interface entre l'isolant et le semiconducteur,
— faible densité de charges électriques dans l'isolant,
— bonne tenue en tension.

Selon ces critères, les MIS sur silicium et plus particulièrement les MOS, c'est à dire des MIS dans lesquels l'isolant est un oxyde, sont d'excellente qualité. Ainsi on utilise très souvent le MOS silicium avec $SiO_2$ comme isolant ou encore le MNOS qui a une structure plus complexe: métal-nitrure de silicium ($Si_3N_4$) — oxyde $SiO_2$ — semiconducteur.

Les MOS silicium fonctionnent en régime d'inversion de charge c'est à dire que l'on polarise la grille métallique de telle manière qu'une charge de type contraire à celui du semiconducteur se forme à l'interface isolant-semiconducteur; par exemple si le semiconducteur est de type p, la grille est polarisée positivement et une charge négative constituée d'électrons se forme dans le semiconducteur, à l'interface avec l'isolant. Cette charge constitue le canal type N du transistor à effet de champ.

Dans les transistors MNOS, la création des charges dans le canal du transistor peut mettre en jeu plusieurs phénomènes plus complexes, permettant leur utilisation dans les circuits logiques à mémoire non-volatile. Ces phénomènes peuvent être décrits succintement comme suit, en prenant comme exemple un transistor de canal N.

A faibles polarisations positives de grille, le transistor MNOS fonctionne selon le même principe que le transistor MOS décrit. Pour des polarisations positives de grille plus importantes, des électrons peuvent traverser la couche d'oxyde $SiO_2$ par effet tunnel, si l'épaisseur de cette couche d'oxyde est faible. Les électrons traversent l'oxyde dans le sens semiconducteuroxyde, et vont se fixer à l'interface oxyde-nitrure en raison de l'existence des pièges à cette interface. Lorsque la polarisation s'annule, les électrons piégés à l'interface oxyde-nitrure induisent une charge positive dans le semiconducteur près de l'interface avec l'oxyde. En raison de cette charge positive, il est nécessaire pour former un canal de charge négative, de polariser la grille plus fortement qu'on ne l'aurait fait avant le piégeage des électrons à l'interface oxyde-nitrure. Il

y a donc un effet de mémoire non-volatile de la forte polarisation créant l'effet tunnel.

Malgré ces possibilités très interessantes les transistors MOS et MNOS sur silicium sont quand même limités en performances. Ces limitations sont dues à la faible mobilité des électrons dans le silicium en comparaison de celle dans GaAs ou d'autres composés du groupe III-V.

Quant aux transistors à effet de champ sur GaAs, ils se limitent surtout aux transistors à grille Schottky, encore appelé MESFET (Metal Schottky field effect transistor). Dans les circuits logiques, les MESFET à canal normalement ouvert impliquent un circuit compliqué et consomment beaucoup d'énergie. Les MESFET à canal normalement bloqué sont de réalisation extrêmement délicate. Dans tous les cas les MESFET ne peuvent pas être utilisés comme les MNOS en tant que mémoire non-volatile. Les MESFET GaAs connus de l'homme de l'art sont souvent de mauvaise qualité car l'interface GaAs — isolant présente une forte densité d'états d'interface.

Dans les demandes de brevets EP-A-0 017 531 et EP-A-0 027 761 au nom de la demanderesse, ont été décrits des transistors MISFET présentant deux couches d'isolant, l'une constituée par $Al_xGa_{1-x}As$, l'autre par un isolant à grande bande interdite tels que $SiO_2$, $Si_3N_4$ ou $Al_2O_3$. L'utilisation de $Al_xGa_{1-x}As$ comme première couche de diélectrique permet de réduire la densité d'états d'interface. Ces MISFET ne permettent pas une utilisation comme mémoire non-volatile.

L'effet de mémoire est décelé dans le brevet US-A-4 160 261. Les auteurs, ont constaté que les transistors MISFET ou MOSFET dont la grille est isolée par une couche de silice ou de nitrure de silicium présentent une hystérésis dans les mesures capacité-tension, et que cette hystérésis fait que le point de fonctionnement du transistor est une fonction des signaux précédemment appliqués. Pour remédier à cette hystérésis, ils ont mis au point un transistor comportant un substrat et une couche active en matériaux III-V (GaAs) et une couche isolante sous la métallisation de grille, cette couche isolante étant adaptée pour s'opposer au passage du courant. En fait, cette couche isolante est en $Al_xGa_{1-x}As$ et a une épaisseur de 7000 Å, ce qui supprime l'effet d'hystérésis.

L'objet de l'invention est au contraire d'exalter l'hystérésis pour obtenir un transistor à effet mémoire.

L'invention vise à satisfaire l'impératif de disposer par exemple d'un transistor sur GaAs présentant des caractéristiques permettant de l'utiliser comme mémoire non-volatile: ce transistor est à double couche de diélectriques, la première jouxtant GaAs est une couche mince d'épaisseur suffisamment faible pour permettre le transfert d'électrons par effet tunnel comme dans les structures MNOS.

De façon plus précise, l'invention consiste en un transistor à effet de champ, à effet de mémoire non-volatile, comportant, supportées par un substrat semi-isolant, deux régions d'accès dites source et drain et une région de commande constituée par une couche active et par une grille de commande, elle-même composée d'une couche mince semi-isolante, d'une couche isolante et d'une couche métallique de prise de contact, ce transistor étant caractérisé en ce que la couche semi-isolante est d'épaisseur inférieure à 100 angströms afin de permettre aux électrons de la traverser par effet tunnel en ce qu'elle est constituée d'un matériau du groupe des semiconducteurs III-V, ayant une bande interdite plus grande que celle du matériau également du groupe des semiconducteurs III-V constituant la couche active et en ce que sa structure et ses paramètres cristallins sont voisins de ceux du matériau de cette couche active.

L'invention sera mieux comprise grâce à la description qui suit et aux figures qui l'accompagne, parmi lesquelles:

La figure 1 représente une coupe schématique d'un transistor MNOS silicium,

les figures 2, 3 et 4 représentent des diagrammes des bandes d'une structure MNOS silicium:

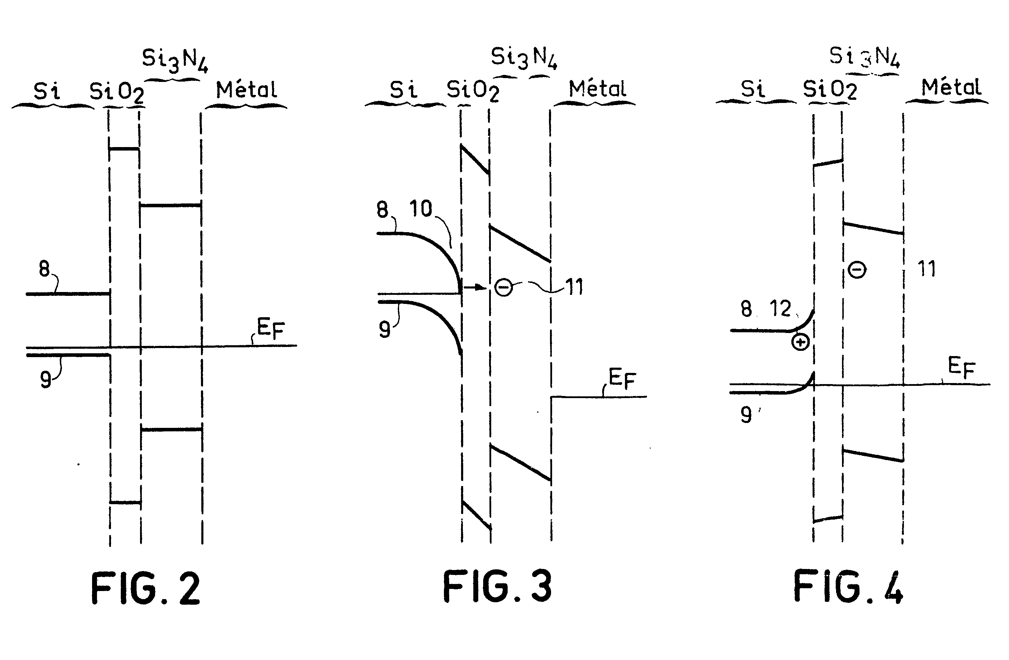

à l'équilibre, sous polarisation positive (fig. 2),
sous polarisation fortement positive (fig. 3),
au retour à polarisation nulle, après l'état précédent (fig. 4),

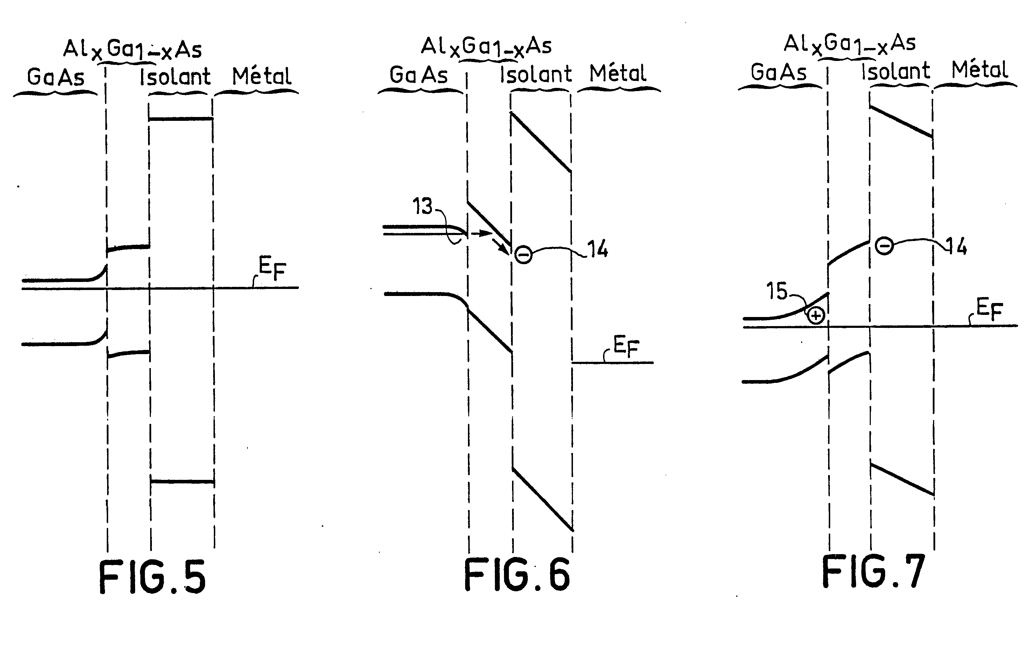

les figures 5, 6 et 7 représentent les diagrammes des bandes d'une structure métal-oxyde-$Al_xGa_{1-x}As$ semi-isolant-GaAs type N:

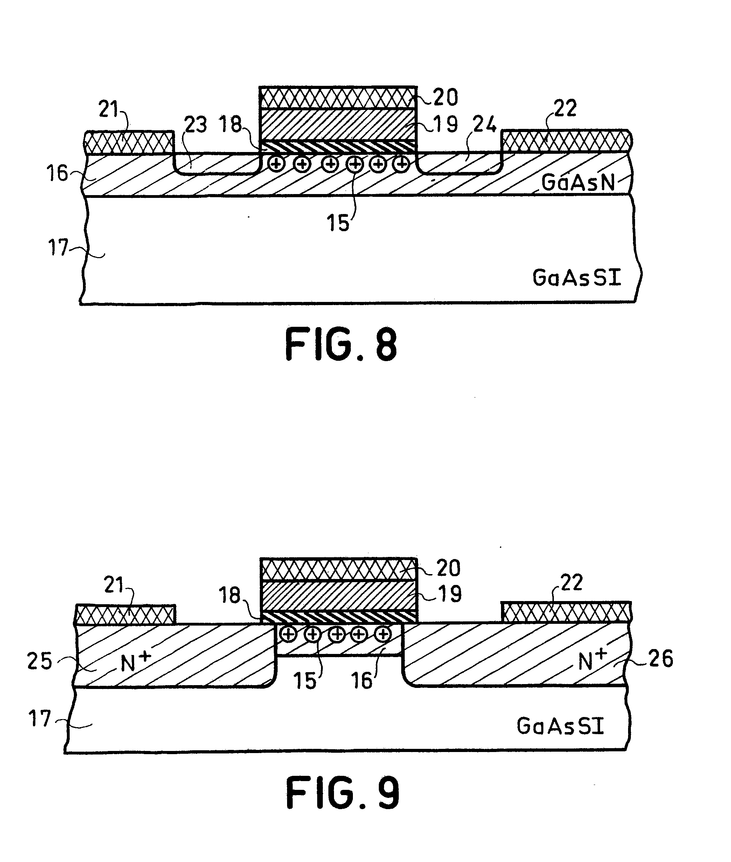

à l'équilibre, sous polarisation nulle (fig. 5),
polarisation fortement positive (fig. 6),
retour à polarisation nulle après l'état précédent (fig. 7),

la figure 8 représente un premier type de transistor à mémoire non-volatile selon l'invention,

la figure 9 représente un deuxième type de transistor à mémoire non-volatile selon l'invention,

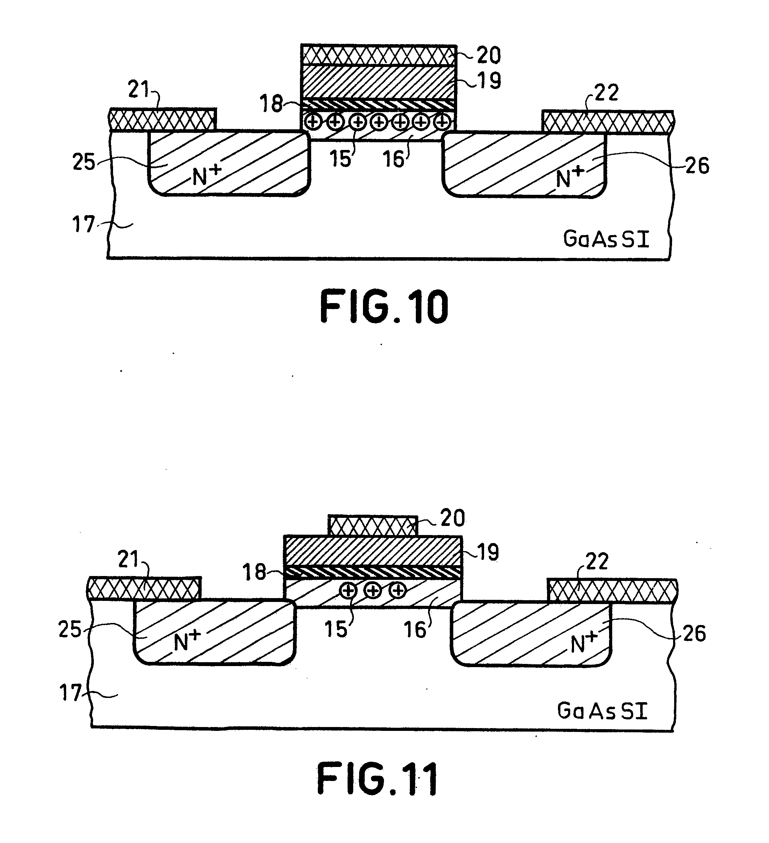

la figure 10 représente un troisième type de transistor à mémoire non-volatile selon l'invention,

la figure 11 représente und quatrième type de transistor à mémoire non-volatile.

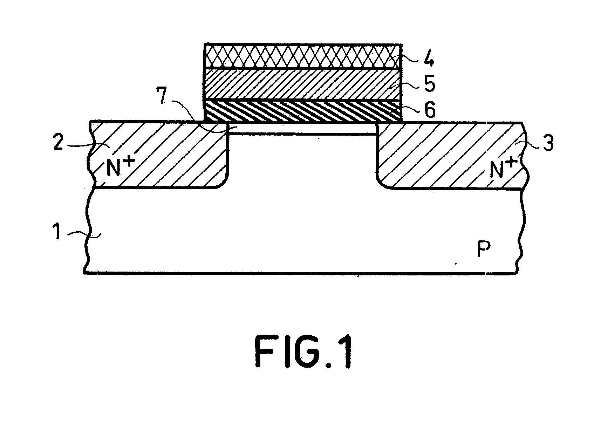

La figure 1 représente un transistor MNOS sur silicium vu en coupe, schématiquement.

A un substrat 1, de type P, par exemple, sont associées deux régions de source 2 et de drain 3, dopées $N^+$ c'est à dire de signe contraire à celui du substrat. La grille est constituée par le métal de prise de contact 4, une couche 5 de nitrure de silicium ($Si_3N_4$) et une couche 6 d'oxyde de silicium ($SiO_2$), qui sont déposés à la surface du substrat, entre les deux régions de source et de drain.

Comme il a été dit, pour une certaine valeur de polarisation positive de la grille, il se crée un canal 7 de charge négative sous la grille. La modulation de la polarisation de grille permet donc de moduler le courant source-drain par l'intermédiaire de ce canal 7. Pour de fortes polarisations de grille, les électrons traversent la couche d'isolant 6 par effet tunnel, si l'épaisseur de celle-ci est de l'ordre de 20 à 40 Å. Ayant traversé la couche 6, les électrons sont piégés à l'interface entre les couches 5 et 6. Lorsque la polarisation grille revient à une valeur nulle, les électrons piégés induisent une charge dans le semiconducteur, charge qui modifie le comportement du canal 7 vis à vis d'une polarisation ultérieure de grille.

Ces phénomènes de transfert d'électrons et d'induction de charge sont explicités sur les figures 2, 3 et 4 qui représentent les diagrammes de bandes d'une structure MNOS.

La figure 2 correspond à une polarisation de grille nulle.

La figure 3 correspond à une polarisation positive: les bandes de conduction 8 et de valence 9 du silicium sont courbées créant une zone d'inversion de charge 10. Si cette polarisation est suffisamment forte, un électron 11 peut traverser la couche mince de $SiO_2$ par effet tunnel. La figure 3 correspond à un effet tunnel direct des électrons contenus dans la couche 10 d'inversion, vers les pièges d'interface entre $SiO_2$ et $Si_3N_4$.

La figure 4 représente le diagramme des bandes de la structure MNOS, revenue à polarisation nulle après avoir subi l'état correspondant à la figure 3. Les électrons 11 induisent une charge 12 positive dans le semiconducteur. Cette charge 12 n'existait pas dans l'état initial de la figure 2.

Les figures 5, 6 et 7 représentent les diagrammes de bandes d'une structure MIS à hétérojonction constituée d'une couche active en GaAs de type N, d'une couche mince en $Al_xGa_{1-x}As$ semi-isolant ($0,2 \leq x \leq 1$) d'épaisseur inférieure à 100 Å, d'une couche d'oxyde isolant et d'une métallisation de grille. C'est dans la couche en GaAs que s'effectuent les opérations de déplétion et d'accumulation de charge. La mobilité des électrons dans GaAs étant bien supérieure à celle dans le silicium, les MIS sur GaAs sont donc des composants rapides et fonctionnant à très haute fréquence, sous la condition que les charges situées dans GaAs et près de l'interface avec l'isolant ne soient pas fixées par les états d'interfaces. La couche en $Al_xGa_{1-x}As$ a la fonction d'isolant, présentant avec GaAs une interface ne comportant que peu de pièges. Des publications sur la détermination de la densité de pièges à l'interface de l'hétérojonction GaAs/$Al_xGa_{1-x}As$ (D. V. Lang et R. A. Logan — Applied Physics Letters 31, no 10, 683 (1977)) et sur l'étude des propriétés de transport à cette interface (R. Dingle, H. L. Stormer, A. C. Gossard et W. Wiegman Applies Physics Letters 33, no 7, 665 (1978)) le prouvent. Cette excellente qualité d'interface s'explique par le fait que GaAs et $Al_xGa_{1-x}As$ ont la même structure cristalline et des paramètres cristallins très voisins. De ce point de vue les composés

$$Ga_xIn_{1-x}P, \; Al_xIn_{1-x}P, \; AlP_xSb_{1-x},$$
$$Al_xGa_{1-x}P_ySb_{1-y}, \; Al_xGa_{1-x}As,$$
$$Ga_xIn_{1-x}P_ySb_{1-y}$$

conviennent également.

La figure 5 représente le diagramme de bandes de la structure MIS à hétérojonction en absence de polarisation grille.

La figure 6 représente la structure d'un MIS à hétérojonction sous polarisation positive de la grille. Il se crée une accumulation 13 d'électrons dans la couche en GaAs. Si la polarisation positive est suffisamment forte, des électrons de la zone 13 d'accumulation peuvent traverser la couche en $Al_xGa_{1-x}As$ par effet tunnel. Si celle-ci est suffisamment mince (de l'ordre de 20 à 50 Å) l'effet tunnel est direct; sinon l'effet tunnel est du type Fowler-Nordheim c'est à dire que l'électron 14 atteint d'abord le bas de la bande de conduction de $Al_xGa_{1-x}As$ avant de se fixer sur un piège à l'interface $Al_xGa_{1-x}As$-isolant. C'est le mécanisme qui est représenté sur la figure 6.

La figure 7 correspond à la structure revenue à polarisation nulle, dans laquelle l'électron 14 induit une charge positive 15 dans le semiconducteur en GaAs provoquant ainsi une région désertée d'électrons, juste à l'interface avec $Al_xGa_{1-x}As$. Si la couche en GaAs est suffisamment mince (inférieure à 1000 Å), elle devient alors complètement dépeuplée d'électrons. On passe ainsi de la figure 5 dans laquelle la couche en GaAs est conductrice, à la figure 7 où elle ne l'est plus. Si la couche en GaAs est plus épaisse, ou si la charge 15 n'est pas suffisamment grande pour que cette couche soit complètement dépeuplée d'électrons, la couche reste conductrice mais son état de charge diffère de ce qu'elle était avant la forte polarisation positive représentée sur la figure 6.

La structure MIS à hétérojonction qui vient d'être décrite ne se limite pas seulement à une couche active en GaAs. Une couche active constituée par un autre semiconducteur du groupe III-V convient également à condition d'utiliser un semiconducteur à grande bande interdite ayant le paramètre de maille adéquate. Ainsi pour une couche active en InP on peut prendre $AlAs_xSb_{1-x}$ ou $AlP_xSb_{1-x}$, et pour une couche active en $Ga_xIn_{1-x}As$ on peut prendre InP, $Al_xIn_{1-x}As$, $AlAs_xSb_{1-x}$, $AlP_xSb_{1-x}$.

La figure 8 représente un premier exemple de transistor à effet de champ MIS à hétérojonction selon l'invention dont le schéma de fonctionnement vient d'être décrit.

La couche active 16 en GaAs de type N est déposée sur un substrat 17 en GaAs semi-isolant, c'est à dire de forte résistivité. La grille est composée d'une succession de couches: la couche 18 en $Al_xGa_{1-x}As$ semi-isolant ou en $Ga_xIn_{1-x}P$, $Al_yIn_{1-x}P$ . . . semi-isolant, d'épaisseur comprise entre une dizaine et une centaine d'angströms; la couche d'isolant 19, d'épaisseur de plusieurs centaines d'angströms; et la métallisation de grille 20. Deux contacts ohmiques 21 de source et 22 de drain, complètent le dispositif. A cause de la disposition des deux contacts 21 et 22 par rapport à la grille, il se crée deux zones 23 et 24 de désertion d'électrons à la surface de GaAs. Pour éviter que la profondeur de ces zones de désertion n'atteigne l'interface entre la couche active 16 et le substrat 17 semi-isolant, l'épaisseur de la couche 16 est relativement élevée, c'est à dire de l'ordre de 1000 à 2000 Å pour un dopage de la couche 16 de l'ordre de $5 \times 10^{16}$ à $10^{17}$ at $\cdot$ cm$^{-3}$. A cause de cette épaisseur, le dispositif fonctionne en régime de déplétion de charge. En d'autres termes, le transistor est normalement ouvert c'est à dire qu'en absence de polarisation de grille, un courant passe entre source et drain. Pour pincer le canal et rendre le transistor en position fermée, il faut polariser la grille négativement à une valeur $V_1 < 0$. Lorsque successivement, une forte tension $V_3$ positive est appliquée à la grille et que l'on revient ensuite à zéro, comme il a été expliqué dans les figures 6 et 7, une charge positive 15 est crée sous la grille. L'épaisseur de la couche 16 étant suffisamment grande pour que la charge 15 ne fasse pas dépeupler complètement les électrons dans le canal du transistor, ce canal reste conducteur et le transistor reste normalement ouvert. Cependant, pour pincer le canal, il faut appliquer une tension négative $V_2$ avec $|V_2| < |V_1|$. Il y a donc effet de mémoire non-volatile.

La figure 9 représente un deuxième exemple de transistor à effet de champ MIS à hétérojonction. Il comporte, comme le premier exemple de la figure 8, un substrat 17 en GaAs semi-isolant, une couche active 16 en GaAs de type N, une grille composée d'une couche 18 semi-isolante, par exemple en $Al_xGa_{1-x}As$, d'une couche 19 d'isolant et d'une métallisation 20. Par contre, les deux contacts ohmiques 21 et 22 sont déposés sur deux caissons 25 et 26 de type N$^+$ c'est à dire à dopage élevé, supérieur à $10^{18}$ at $\cdot$ cm$^{-3}$. Ces deux caissons sont en contact avec la grille et peuvent même pénétrer légèrement en dessous d'elle, afin d'éliminer les deux zones de charge d'espace 23 et 24 présentés dans la structure de la figure 8. L'adjonction de ces deux caissons N$^+$ 25 et 26 permet donc de réduire l'épaisseur de la couche 16 en dessous de 1000 Å, pour un dopage de $5 \times 10^{16}$ à $10^{17}$ at $\cdot$ cm$^{-3}$. Cette réduction permet d'avoir un canal conducteur en l'absence de toute polarisation de la grille et un canal non conducteur si une forte tension de grille est appliquée et que l'on revient ensuite à zéro comme il a été expliqué dans les figures 6 et 7. En d'autres termes, le transistor peut être normalement ouvert ou normalement bloqué selon les traitements électriques subis au préalable par la grille. Cette nouvelle possibilité de mémoire non volatile s'ajoute à l'effet sur la différence de tension de commande $V_1$ et $V_2$ de grille expliqué précédemment avec $V_1 < 0$ et $V_2 > 0$. On peut uti liser ce transistor en situation toujours normalement bloqué donc $V_1$ et $V_2 > 0$, à condition de polariser fortement la grille à deux valeurs $V_3$ et $V'_3$ différentes.

La figure 10 représente un troisième exemple de transistor MIS à hétérojonction selon l'invention. C'est une variante du transistor de la figure 9. La différence concerne la position des deux caissons $N^+$ 25 et 26 par rapport aux couches 16 en GaAs et 18 en $Al_xGa_{1-x}As$. Dans l'exemple de la figure 10, les deux caissons 25 et 26 sont en contact avec la couche 16 mais ne le sont pas avec la couche 18. On évite ainsi une possibilité pour les électrons ayant traversé la couche 18 par effet tunnel, d'être drainés en partie par la tension source-drain. Les deux caissons 25 et 26 peuvent être juste en contact avec la couche 16 ou être partiellement dans ladite couche.

La figure 11 représente un quatrième exemple de transistor à effet de champ MIS à hétérojonction selon l'invention. C'est une variante du transistor des figures 9 et 10. La différence concerne la métallisation de grille 20, qui ne recouvre pas complètement la couche d'isolant 19. Cette structure permet donc de réduire la longueur de grille sans avoir à réduire la longueur équivalente de l'oxyde ce qui constitue quelques avantages de technologie.

Une autre variante des structures représentées sur les figures 9 et 10, consiste à utiliser une couche active 16 dopée à un niveau inférieur à $10^{14}$ at $\cdot$ cm³ au lieu d'une couche conductrice de type N. Dans ce cas les transistors fonctionnent toujours en régime normalement bloqué. Les tensions de travail de la grille sont toujours positives, avec $V_1 < V_2$.

**Revendications**

1. Transistor à effet de champ, à effet de mémoire non-volatile, comportant, supportées par un substrat (17) semi-isolant, deux régions d'accès dites source (21) et drain (22) et une région de commande constituée par une couche active (16) et par une grille de commande, elle-même composée d'une couche mince (18) semi-isolante, d'une couche (19) isolante et d'une couche (20) métallique de prise de contact, ce transistor étant caractérisé en ce que la couche (18) semi-isolante est d'épaisseur inférieure à 100 angströms (1 Å = 0,1 nm) afin de permettre aux électrons de la traverser par effet tunnel, en ce qu'elle est constituée d'un matériau du groupe des semiconducteurs III-V, ayant une bande interdite plus grande que celle du matériau également du groupe des semiconducteurs III-V constituant la couche active (16) et en ce que sa structure et ses paramètres cristallins sont voisins de ceux de ladite couche active (16).

2. Transistor à effet de champ selon la revendication 1, caractérisé en ce que, le matériau de la couche active (16) étant l'arséniure de gallium GaAs, le matériau de la couche (18) semi-isolante est choisi parmi:

$Ga_xIn_{1-x}P$, $Al_xIn_{1-x}P$, $AlP_xSb_{1-x}$, $Al_xGa_{1-x}As$, $Al_xGa_{1-x}P_ySb_{1-y}$, $Ga_xIn_{1-x}P_ySb_{1-y}$.

3. Transistor à effet de champ selon la revendication 1, caractérisé en ce que, le matériau de la couche active (16) étant choisi parmi le phosphure d'indium InP ou $Ga_xIn_{1-x}As$, le matériau de la couche (18) semi-isolante est choisi parmi $AlAs_xSb_{1-x}$, $AlP_xSb_{1-x}$, $Al_xIn_{1-x}As$.

4. Transistor à effet de champ selon la revendication 1, caractérisé en ce que la couche active (16) est dopée de type N, à $5 \cdot 10^{16}$ à $10^{17}$ at/cm³, est d'une épaisseur comprise entre 1000 et 2000 angströms, et s'étend sous les métallisations de prise de contact de source et de drain (21 et 22).

5. Transistor à effet de champ selon la revendication 1, caractérisé en ce que la couche active (16) est dopée de type N, à $5 \cdot 10^{16}$ à $10^{17}$ at/cm³, est d'épaisseur inférieure à 1000 angströms, et est en contact avec deux caissons (25 et 26) dopés $N^+$ à un niveau supérieur à $10^{18}$ at/cm³, réalisés dans l'épaisseur du substrat.

6. Transistor à effet de champ selon la revendication 5, caractérisé en ce que les caissons (25 et 26) sont en outre en contact avec la couche (18) semi-isolante.

7. Transistor à effet de champ selon la revendication 5, caractérisé en ce que la couche active (16) est en saillie par rapport au substrat (17), dans lequel elle pénètre et est en contact avec les caissons (25 et 26).

8. Transistor à effet de champ selon la revendication 1, caractérisé en ce que la couche active (16) est dopée à un niveau inférieur à $10^{14}$ at/cm³.

9. Transistor à effet de champ selon l'une quelconque des revendications précédentes, caractérisé en ce que la métallisation (20) de grille recouvre partiellement la couche isolante (19).

**Patentansprüche**

1. Feldeffekttransistor mit nicht-flüchtiger Speicherwirkung, mit einem halbisolierenden Trägersubstrat (17), auf dem zwei Zugangszonen, nämlich Source (21) und Drain (22) und eine Steuerzone aufgebracht sind, die aus einer aktiven Schicht (16) und einem Steuergitter besteht, wobei dieses Gitter wieder aus einer dünnen halbisolierenden Schicht (18) einer Isolierschicht (19) und einer metallischen Kontaktgabeschicht (20) besteht, dadurch gekennzeichnet, daß die halbisolierende Schicht (18) eine Dicke von weniger als 100 Angström (1 Å = 0,1 nm) aufweist, so daß die Elektronen diese Schicht aufgrund des Tunneleffekts durchqueren können, und daß die halbisolierende Schicht (18) aus einem Material der Halbleitergruppe III bis V besteht, das ein größeres verbotenes Band als das die aktive Schicht (16) bildende, ebenfalls der Halbleitergruppe III bis V angehörende Material besitzt, und daß die Struktur und die Kristallparameter dieses Materials der Struktur und den Kristallparametern der aktiven Schicht (16) ähneln.

2. Feldeffekttransistor nach Anspruch 1, dadurch gekennzeichnet, daß das Material der aktiven Schicht (1) Galliumarsenid GaAs ist, während das Material der halbisolierenden Schicht aus der Gruppe ausgewählt ist, die besteht aus

$$Ga_xIn_{1-x}P, \ Al_xIn_{1-x}P, \ AlP_xSb_{1-x},$$
$$Al_xGa_{1-x}As, \ Al_xGa_{1-x}P_ySb_{1-y},$$
$$Ga_xIn_{1-x}P_ySb_{1-y}.$$

3. Feldeffekttransistor nach Anspruch 1, dadurch gekennzeichnet, daß das Material der aktiven Schicht (16) Indiumphosphid InP oder $Ga_xIn_{1-x}As$ ist, während das Material der halbisolierenden Schicht (18) aus der Gruppe von Materialien ausgewählt wird, die enthält $AlAs_xSb_{1-x}, AlP_xSb_{1-x}, Al_xIn_{1-x}As$.

4. Feldeffekttransistor nach Anspruch 1, dadurch gekennzeichnet, daß die aktive Schicht (16) vom Typ N mit $5 \cdot 10^{16}$ bis $10^{17}$ Atomen/cm$^3$ dotiert ist, eine Dicke von 1000 bis 2000 Angström aufweist und sich unter den Kontaktgabemetallisierungen der Source und des Drains (21 und 22) erstrecken.

5. Feldeffekttransistor nach Anspruch 1, dadurch gekennzeichnet, daß die aktive Schicht (16) vom Typ N mit $5 \cdot 10^{16}$ bis $10^{17}$ Atomen/cm$^3$ dotiert ist, eine Dicke von unter 1000 Angström besitzt und mit zwei Bereichen (25 und 26) in Kontakt steht, die mit mehr als $10^{18}$ Atomen/cm$^3$ vom Typ N$^+$ dotiert sind und in der Dicke des Substrats realisiert sind.

6. Feldeffekttransistor nach Anspruch 5, dadurch gekennzeichnet, daß die Bereiche (25 und 26) außerdem mit der halbisolierenden Schicht (18) in Kontakt stehen.

7. Feldeffekttransistor nach Anspruch 5, dadurch gekennzeichnet, daß die aktive Schicht (16) über das Substrat (17) vorsteht, in das sie eindringt und in dem sie mit den Bereichen (25 und 26) in Kontakt steht.

8. Feldeffekttransistor nach Anspruch 1, dadurch gekennzeichnet, daß die aktive Schicht (16) mit weniger als $10^{14}$ Atomen/cm$^3$ dotiert ist.

9. Feldeffekttransistor nach einem beliebigen der vorhergehenden Ansprüche, dadurch gekennzeichnet, daß die Gittermetallisierung (20) die isolierende Schicht (19) teilweise überdeckt.

## Claims

1. A field effect transistor with a non-volatile memory effect, comprising, supported by a semi-insulating substrate (17), two access regions called source (21) and drain (22), and a control region constituted by an active layer (16) and by a control grid, the latter being composed of a thin semi-insulating layer (18), of an insulating layer (19) and of a metal contact layer (20), characterized in that the semi-insulating layer (18) has a thickness below 100 Angström (1 Å = 0,1 nm) so as to permit the passage of electrons therethrough by the tunnel effect, that this layer (18) is made from a material of the semi-conductor groupe III-V having a broader forbidden band than the material forming the active layer (16) and being also of the semi-conductor group III-V, and that the structure and the cristal parameters of the layer (18) are close to those of said active layer.

2. A field effect transistor according to claim 1, characterized in that the material of the active layer (16) being gallium arsenide GaAs, the material of the semi-insulating layer (18) is chosen from

$$Ga_xIn_{1-x}P, \ Al_xIn_{1-x}P, \ AlP_xSb_{1-x},$$
$$Al_xGa_{1-x}As, \ Al_xGa_{1-x}P_ySb_{1-y},$$
$$Ga_xIn_{1-x}P_ySb_{1-y}.$$

3. A field effect transistor according to claim 1, characterized in that the material of the active layer (16) being chosen from indium phosphide InP or $Ga_xIn_{1-x}As$, the material of the semi-insulating layer (18) is chosen from $AlAs_xSb_{1-x}$, $AlP_xSb_{1-x}, Al_xIn_{1-x}As$.

4. A field effect transistor according to claim 1, characterized in that the active layer (16) is doped according to the N-type with $5 \cdot 10^{16}$ to $10^{17}$ atoms/cm$^3$, that its thickness is included between 1000 and 2000 Angström and that it extends under the contact metallisation of the source and the drain (21 and 22).

5. A field effect transistor according to claim 1, characterized in that the active layer (16) is doped according to the N-type with $5 \cdot 10^{16}$ to $10^{17}$ atoms/cm$^3$, that its thickness is below 1000 Angström and that it is in contact with two boxes (25 and 26) which are N$^+$ doped to a level above $10^{18}$ atoms/cm$^3$ formed in the thickness of the substrate.

6. A field effect transistor according to claim 5, characterized in that the boxes (25 and 16) are also in contact with the semi-insulating layer (18).

7. A field effect transistor according to claim 5, characterized in that the active layer (16) projects beyond the substrate which it penetrates and which is in contact with the boxes (25 and 26).

8. A field effect transistor according to claim 1, characterized in that the active layer (16) is doped to a level below $10^{14}$ atoms/cm$^3$.

9. A field effect transistor according to any one of the preceding claims, characterized in that the metallisation (20) of the grid partly covers the insulating layer (19).

FIG.1

FIG. 2  FIG. 3  FIG. 4

0 046 422

Al$_x$Ga$_{1-x}$As
GaAs | Isolant | Métal

E$_F$

**FIG.5**

Al$_x$Ga$_{1-x}$As
GaAs | Isolant | Métal

13

14

E$_F$

**FIG.6**

Al$_x$Ga$_{1-x}$As
GaAs | Isolant | Métal

14

15

E$_F$

**FIG.7**

0 046 422

FIG. 8

FIG. 9

FIG.10

FIG.11